# EUROPEAN PATENT APPLICATION

(11) **EP 1 150 223 A2**
(43) Date of publication of application: **31.10.2001**
(21) Application number: 01303640.5
(22) Date of filing: 20.04.2001
(51) Int. Cl.: G06F 17/50

(54) **Structural design system**

(30) Priority: 20.04.2000 GB 0009651
(71) Applicant: Metsec PLC, Warley, West Midlands B69 4HE (GB)
(72) Inventor: Burns, Roy, Staffordshire WS15 4RS (GB)
(74) Representative: Hackett, Sean James

(57) **Abstract**

The invention provides a structural design system for facilitating design of a building structure. A user input (10) receives user-selected parameters, an alternative parameter and user-specified data relating to the building structure. An output (26) presents structural member design options and/or alternative structural member design options. A data memory (18) stores data to be processed, including the user-specified data and reference data. An instruction memory (24) stores a program comprising instructions for controlling a processor (22) to generate wind load values which may be imposed on the building by wind in dependence on the user selected parameters, data read from the data memory (18) and a predetermined wind load algorithm, and to store the wind load values. Structural member design options are calculated on the basis of the user selected parameters, data read from the data memory (18), the wind load values and predetermined structural design criteria. Alternative structural member design options are calculated on the basis of the user-selected alternative parameter and the plurality of wind load values.

## Description

This invention relates to a structural design system for steel framed building structures and in particular but not exclusively to a structural design system for selecting purlins and side rails in such structures.

Conventional structural design systems, which aid the design of steel framed building structures, enable selection of structural members such as purlins or side rails which may be optimal for a given building specification. However, such systems are limited to selecting the structural member options on the basis of a limited range of design parameters. More particularly, the designer is unable to store design options for subsequent comparison with design options calculated according to alternative criteria. He is required to input all of the parameters required by the system every time he wishes to generate a set of options based on a variation in the design criteria or design parameters.

According to the present invention, there is provided a structural design system for a building structure comprising: a user input for receiving user-selected parameters, a user-selected alternative parameter and user-specified data relating to said building structure; an output for presenting structural member design options and/or alternative structural member design options; and a processing apparatus for processing data, the processing apparatus comprising:
a data memory operable to store data to be processed, including said user-specified data and reference data;
an instruction memory for storing a program comprising processor implementable instructions;
a processor operable to read and process data in accordance with said program;
wherein said program comprises instructions for controlling the processor to:
   generate a plurality of wind load values which may be imposed on the building by wind in dependence on said user selected parameters, data read from said data memory and a predetermined wind load algorithm;
   store said plurality of wind load values;
   calculate structural member design options on the basis of said user selected parameters, data read from said data memory, said plurality of wind load values and predetermined structural design criteria; and
   calculate alternative structural member design options on the basis of said user-selected alternative parameter and said plurality of wind load values.

Preferably, said user-specified data includes data relating to a structural system and/or a structural type and/or positional data and/or dimensional data of said building structure.

The program may further include instructions for controlling the processor to calculate said alternative structural member design options for a selected part of the building structure to facilitate determination of a common structural member design type or size for the building structure.

According to the present invention, there is further provided a method of structural design for a building structure comprising:
receiving user-selected parameters and user-specified data relating to a said building structure including positional and dimensional data;
generating a plurality of wind load values which may be imposed on the building by wind in dependence on said positional and dimensional data;
storing said plurality of wind load values;
calculating structural member design options on the basis of said user selected parameters, data read from a data memory, said plurality of wind load values and predetermined structural design criteria; and
calculating alternative structural member design options on the basis of a received user-selected alternative parameter and said plurality of wind load values.

The method may further include calculating said alternative structural member design options for a selected part of the building structure to determine a common structural member design type or size for the building structure.

Embodiments of the invention have the advantage that they allow a building designer to obtain and view scrollable design options for the structural members according to alternative structural design parameters on entry into the system of only those parameters to be changed. This avoids the re-entry of unchanged data that the system carries through to the alternative calculation. Moreover, embodiments permit calculation of the structural member design options for the whole building in a single design process or sequence. The system can do this because it provides for the entry of the required parameters appertaining to all surfaces of the building in preparation for calculating the structural member design options. In other words, the system prompts the designer for all the information it needs to do all relevant structural calculations up front.

The system allows the designer to select parameters from a list of options. A parameter may be a structural system type or an optional variant thereof. For any parameter selected, the system may further prompt the designer to enter data, for example dimensional data, related to the selected parameter.

A further advantage is that once structural member design options have been calculated for one part of a building structure, options may be calculated for other parts and alternative options determined that allow the designer to match the options so as to find a single type and/or common size of structural member for the building.

The user-selected parameters may include the structural system type, which may include roof purlins or side rails. In a more sophisticated system, the system types may further include bracing and posts, ceiling/services and eaves beam options.

The structural system parameters, which the system may provide for the designer to select from, may depend on the structural system type previously selected. For example, in the case where the selected system type is roof purlins, the parameters will pertain to roof purlins. In this case, the system may be provided with means, in the form of 'drop down boxes' to allow the designer to select between sleeved, butt, overlap and heavy end bay roof purlin design parameters. The system may prompt for additional design data impinging on the calculation of the purlin member options, including: the cladding type (e.g. metal, cement or non-restraining cladding), span, centres, dead loading, service and imposed loading. The system may provide options for selecting between parameters and data for roof purlins in the case of a steep roof slope, a tiled roof or cantilever. The system may further provide for options permitting the designer to select structural design parameters and data, which take into account snow accumulation on the roof. One such option provides for the entry of data relevant to snow accumulation along the roof span, the other across centres.

In the case where the selected system type is side rails, the system may prompt the designer to select between Z or C sleeved/butt profiled rails. The system may call for the entry of span and distance between centres as well as cladding weight in order that these data may be taken into account in the calculation of the structural member options.

The positional data may be geographical location defined by an ordnance survey grid reference. Alternatively the location may be defined by specifying a named location (e.g. town name), and a database used to identify the grid reference. This data may include information as to the terrain in which the building is located. Terrain information may include, for example, obstruction height or average height of rooftops upwind of the building under consideration, distance to the obstruction, distance in town and distance from the sea in one or more directions. Topographical data may also be included in the positional data, such as site altitude and the gradient of surrounding land.

The dimensional data may include one or more of the building height, dimensional information of the roof and gables, building orientation, building type (i.e. whether single or multi-bay), roof type (i.e. whether flat, hipped, duo-pitch or mono-pitch).

The reference data may be in the form of one or more databases and/or one or more look-up tables. In preferred embodiments the reference data may include a database of wind speeds based on geographical grid location, a database of geographical grid locations based on town names, and look-up tables for facilitating determination of dynamic wind pressure from wind speed data using a method defined in BS6399 part 2.

The computer program may include instructions for implementing calculation by the processor of:
equivalent site altitude, basic wind speed, upwind distance from the sea, and upwind distance from the edge of a town based on the positional and dimensional data and reference data;
default obstruction height, default separation from neighbouring buildings and terrain factors;
dynamic wind pressures in each orthogonal direction on each wall face of said building structure;
pressure coefficients based on dynamic wind pressures and dimensional data of the building structure;
wind loads on each wall and roof surface due to wind speeds in parallel and orthogonal directions and a gravity load for each wall and roof structure; and
structural member loads for predetermined structural member criteria using a finite element analysis method. The predetermined structural member criteria may include cross section dimensions and material thicknesses of a selection of known manufactured structural members.

The structural design system embodying the invention may be effected by configuring a computer to carry out the functional steps of the system. The computer may be configured by way of a computer program recorded on a carrier, such as a CD-ROM or floppy disk. The computer program may be downloaded via the Internet and run on the designer's personal computer. Alternatively, the structural design system may be run on an Internet accessible server, the calculated structural member options being transmitted to and displayed on the client (i.e. designer's) personal computer.

According to the present invention, there is further provided a computer program carrier product which when run on a computer:
provides for receiving a user-selection of parameters, a user-selection of an alternative parameter and user-specified data relating to a building structure including positional and dimensional data;
generates a plurality of wind load values which may be imposed on a building by wind in dependence on said positional and dimensional data;
stores the said plurality of wind load values,
calculates structural member design options on the basis of said parameters, reference data read from a data memory, said plurality of wind load values and predetermined structural design criteria; and
calculates alternative structural member design options on the basis of said user-selected alternative parameter and said plurality of wind load values.

The carrier product may further contain said reference data. The reference data may be copied from the carrier product to the data memory of the computer or may be read directly from the carrier product. The computer program carrier product may be a CD-ROM or data downloaded via the Internet.

Embodiments of the invention have the advantage that they provide an interface between calculation routines involving common parameters which may be independently stored and recalled for input into fresh calculations on the basis of variable parameters. Common parameters relevant to the calculation of the structural member options includes, for example, the wind load values due to wind loading. This parameter is common to different design calculations the designer may wish to produce in relation to the building structure. Variable parameters are the different parameters which the designer can choose between (e.g. purlins or side rails and design details thereof or one of these in conjunction with chosen parameters) to see how alternatives affect the structural member options available. This avoids any need for the designer to re-enter data common to old and new calculations. That is, the system carries through design parameters which are applicable to more than one design scenario.

The invention will be further described by way of example with reference to the accompanying drawings, in which:
Figure 1 is a schematic diagram showing the structure of a computer system embodying the invention;
Figure 2 is a schematic diagram of the functional components of a system embodying the invention; and
Figures 3 and 4 are flow charts with reference to which the operation of a system and method embodying the invention will be explained.

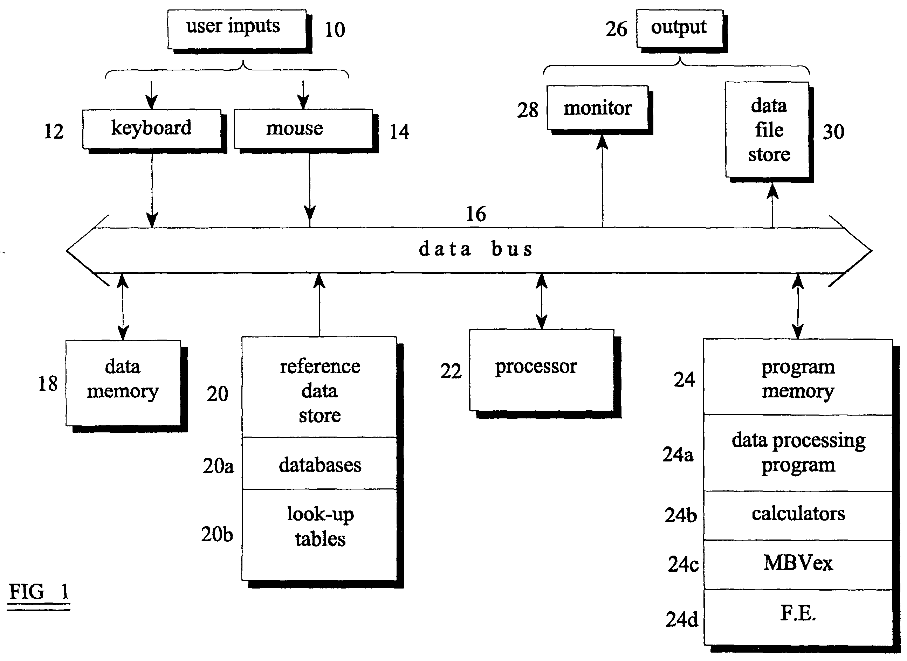

Referring to Figure 1, a computer system has user inputs 10, including a keyboard 12 and a mouse 14. Information is passed between components of the system in the form of electronic signals along a data bus 16. The system further comprises: a data memory 18; a reference data store 20, including data bases 20a and look-up tables 20b; a processor 22; a program memory 24; and outputs 26, including a visual display monitor 28 and a data file store 30. The program memory 24 includes a data processing program 24a, calculators 24b, a wind speed determining program entitled M_BVex 24c, and a finite element (FE) structural analysis program 24d. The data file store 30 may be a directory on the hard disk drive of the computer, or a removable file store such as a floppy disk.

In an alternative embodiment, the user input may be operable to receive input signals from a remote computer operated by a user and communicating with the system via a network, for example the Internet. Similarly, the outputs may be operable to transmit output signals to the remote computer via the network.

In use, programs 24a, 24b, 24c, 24d are loaded from the program memory 24 into the processor 22. The programs contain instructions for processing of data. Data in the form of building structure and site location information is entered by a user on the keyboard 12. The programs also present lists of options on the monitor 28 for selection by the user with the mouse 14. Data is stored in the data memory 18 and retrieved from the store by the processor 22 when required.

Instructions in the programs 24a, 24b, 24c, 24d, instruct the processor to retrieve data from the data memory 18 and the reference data store 20, and to process the data according to the method described below so as to provide structural member design options for display on the monitor 28 and storage in the data file store 30.

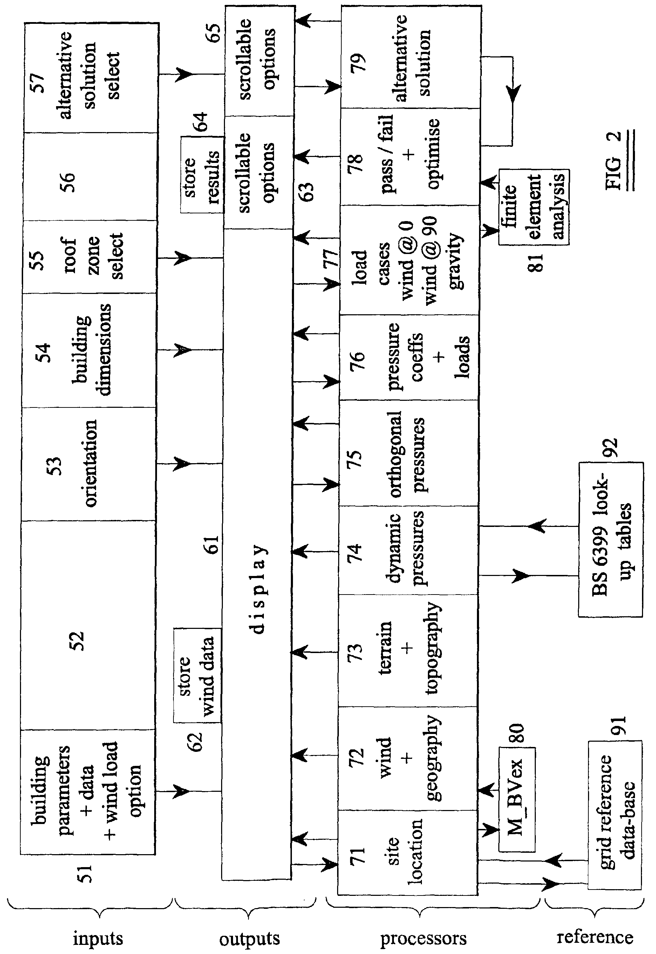

Referring to Figure 2, system input functions are shown in boxes denoted by reference numerals 51 to 57, system output functions by boxes 61 to 65, system processing functions by boxes 71 to 81, and system reference data retrieval functions by boxes 91 and 92. The functions proceed in the directions of the arrows shown in Figure 2 and from left to right

The system input functions 51 to 57 may require the user to input a parameter by selecting from a list of options displayed on the monitor screen, for example using drop-down boxes or clicking on a button or icon, or may require data to be input into data fields displayed on the screen. Therefore it will be understood that the monitor display 61 functions both as an output and as a user interface. Futhermore, the system operates such that the user is prompted to provide inputs and may select from various options throughout the process. Only some of the inputs are shown in Figure 2, with inputs at 52 and 56 omitted for clarity. Throughout the processing of data all the processors are operable to store the processed data in the data memory 18 of Figure 1, for subsequent retrieval when required by other processors.

The system functions shown in Figure 2 commence with an input of building parameters and data and selection of a wind load calculating option in box 51. Site location processor 71 is operable for processing these input data and parameters to provide data for the selected wind load calculator, which may be the M_BVex program 80. The site location processor 71 may access grid reference data from the grid reference database 91. The site location processor 71 provides results of the site location processing for display at 61. The M_BVex program is operable to calculate wind speed data and provide this to a wind and geography processor 72. Similar data may be provided by other selectable wind speed calculators. Wind and geography processor 72 is operable to determine equivalent site altitude, basic wind speed, upwind distance from the sea and upwind distance from the edge of town. These data are stored in a wind data file 62, and are provided to a terrain and geography processor 73 which is operable to calculate a default obstruction height, a default building separation and data relating to the terrain in the town or countryside of the specified site location.

A dynamic pressure processor 74 is operable to process data provided by the preceding processors 71, 72, 73, to calculate the dynamic pressures in 12 wind directions according to the procedure of BS6399, by retrieving data from look-up tables 92.

Input 53 requires the user to input the orientation of the building structure. Orthogonal pressure processor 75 is operable to determine the dynamic pressure on each wall face of the building structure due to the wind in orthogonal directions, i.e. parallel and perpendicular to each wall face.

Input 54 contains the dimensions of the building structure. These are required by a pressure coefficient and load processor 76, which determines the pressure coefficients and loads on each wall and roof surface.

Input 55 contains a user-selected roof zone. This is provided to a load case processor 77, which is operable to determine load cases for wind in each orthogonal direction and gravity acting on the structural members. These load cases provide an input to a finite element structural analysis program 81, which is operable to determine the internal forces carried by the structural members. Finite element program 81 is operable to analyse a range of structural member sizes for each load case to provide a range of structural member options. The structural member sizes may be predetermined to be those of known manufactured structural member products.

A pass/fail and optimise processor 78 is operable to compare the results output by the finite element program 81 with predetermined criteria (such as maximum allowable working stresses) to determine whether a structural member option passes or fails. A scrollable list of the structural member options is displayed on an output screen 63 and the results stored in a results file 64. The pass/fail and optimise processor 78 is further operable to determine an optimum structural member size based on the lowest weight of structural member that passes the predetermined criteria.

Input 57 is a user selection of an alternative solution. When selected an alternative solution processor 79 is operable for providing a display of user-selectable alternative parameters, which are then used to provide an alternative set of scrollable structural member options for output to a display screen 65.

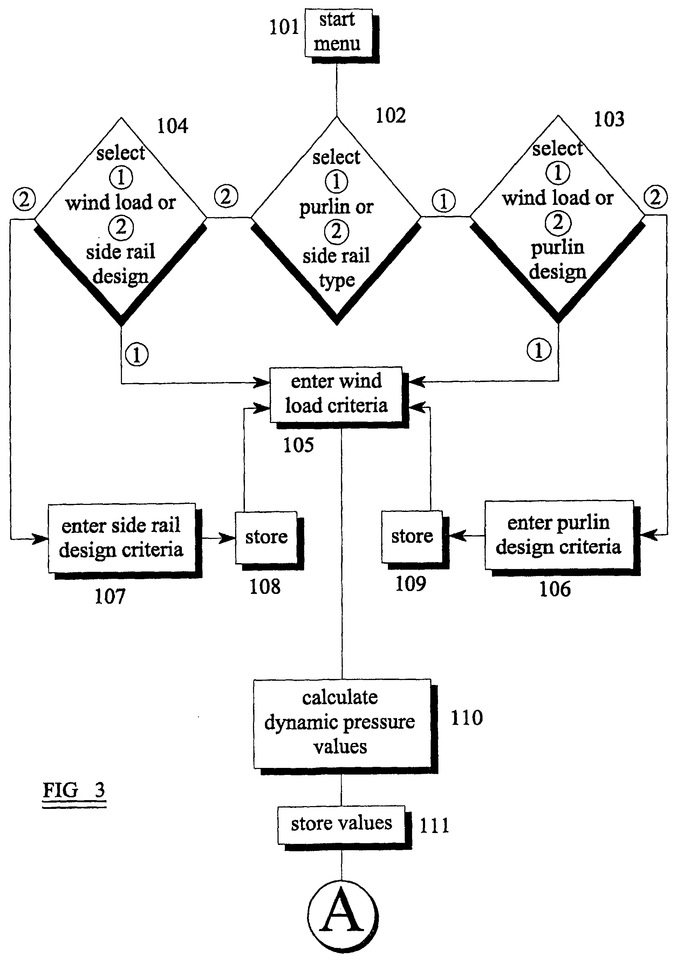

In step 101 of Figure 3, the structural design system embodying the invention is started. At step 102, a menu is displayed on a building designer's computer monitor to permit selection between different structural system types, in this case a roof purlin or a side rail system type. Selection of the structural system type generates a menu providing the designer with a plurality of icons from which a structural design parameter or wind load parameter may be specified. In the case of purlin selection, at step 102, icons may be generated and displayed for providing for the entry of purlin design parameters or wind load selection at step 103. In the case of side rail selection at step 102, the system may generate and display icons for the entry of side rail design parameters or wind load option at step 104. If a wind load option is selected at step 103 or 104, the system prompts the designer for wind load parameters in a manner described below at step 105. If purlin or side rail design parameters are selected at step 103 or 104, the system prompts the designer for relevant data at steps 106 and 107 respectively. Following entry of the data at steps 106 and 107, the system stores the design data/parameters in a memory at steps 108 and 109 respectively.

At step 106, the system may prompt the designer for purlin parameters relevant to a selected one of a steep roof slope, tiled roof or cantilever situation. Each of these cases may be represented by an appropriately marked icon. When the designer clicks on the icon of choice, the system prompts him for entry of the structural design parameters relevant to that choice.

The designer may opt for selecting a wind load option at step 103 or 104 following which the system prompts him for wind load data at step 105. In this embodiment, the designer may choose to calculate these values according to any one of four calculation routines based on uniform wind loading, stepped loading, the 'CP3' system as known in the art, or the 'BS6399' system as known in the art. The latter system provides for calculation of the wind load values taking into account variables such that the values are most representative of those affecting the building under design as will be described in more detail below.

At step 105, the system presents the designer with a series of prompts for positional and dimensional parameters and data from which the system generates the wind load values representing the wind loading on the building. Each prompt generates a form directed to collecting specific data relating to the positional and dimensional aspects of the building design. For example, a first prompt generates a form which prompts the designer to select between determining the values on the basis of the worst case (i.e. the most severe wind direction being adopted for all directions), on the basis of wind from four orthogonal directions or 12 wind directions. In other words the wind load values which may be imposed on the building may be calculated according to a degree of resolution determined by the designer. In the case where the values are determined in respect of 4 directions, the generation means preferably calculates them according to the 'worst case' scenario within that quadrant.

Means may be provided for linking the positional parameters to a wind map of average or peak wind speeds for a selected geographical grid location. The M_BVex program 24c (see Figure 1) contains a method of determining maximum wind speeds in 12 wind directions. The program uses a database of geographical data and algorithms based on distances from the sea and, for buildings in towns, the distance from the edge of the town. A further database permits the geographical location to be determined by specifying a location (town, village name etc.) to determine a grid location.

The system calculates wind load values for the roof and walls of the building independently of one another so that the system is able to take into account the location of gable ends in a single or multi-bay building. In a single bay building, the gable end is generally on the short side while in a multi-bay building the gables are generally on the long side.

Another prompt may include a form permitting entry by the designer of altitude information, wind speed for the building location, basic building size information, including roof type (i.e. flat, duo-pitch, monopitch, hipped). Further prompts may generate forms providing for the entry of information pertaining to site terrain, topography, roof orientation, wall orientation, the calculation of roof and wall external pressure coefficients, the calculation of roof and wall internal pressure coefficients, roof and wall loads. These prompts may be initiated by way of icons displayed on the designer's monitor. Means may be provided for highlighting the icons according to a predetermined sequence so that the form in respect of any given icon is only openable provided that a predetermined preceding form has been completed by the designer. In this case, the system initially highlights only one icon, for example, the icon pertaining to the number of desired wind directions. On selection of this option, the next icon in the desired sequence is highlighted whereby the designer is able to enter further data relevant to the calculation of the dynamic wind load values. Once the wind load data/parameters are entered, the designer may click on an 'apply' button which activates the system to calculate the wind load values according to predetermined algorithms and reference tables at step 110.

The system is provided with means for displaying the wind loads against a scale representation of the building as they are calculated for each aspect thereof. Means may be provided for colour coding the zones of the roof and or walls to which the values apply for ease of identification. Scale representations may be provided for the wind loads in relation to wind incident orthogonally on each wall face and on the roof having regard to the 'worst case' condition. In one example, the representation for the roof wind loads may comprise a plan view of the building showing scaled zones representing the wind load values when the wind is incident from the longer side of the building, and a separate plan view of the building showing scaled zones when the wind is incident from the gable end side of the building. In the former case, the eaves, ridge and general roof area may be indicated by different zones respectively. These zones may be subdivided into sub-zones representing the end regions and central region of the building. In the latter case, the zones may represent the wind load values at the gable end, intermediate region and general roof area downstream of the incident wind direction. Again, the gable end zone may be sub-divided to represent the values in the central regions and end regions.

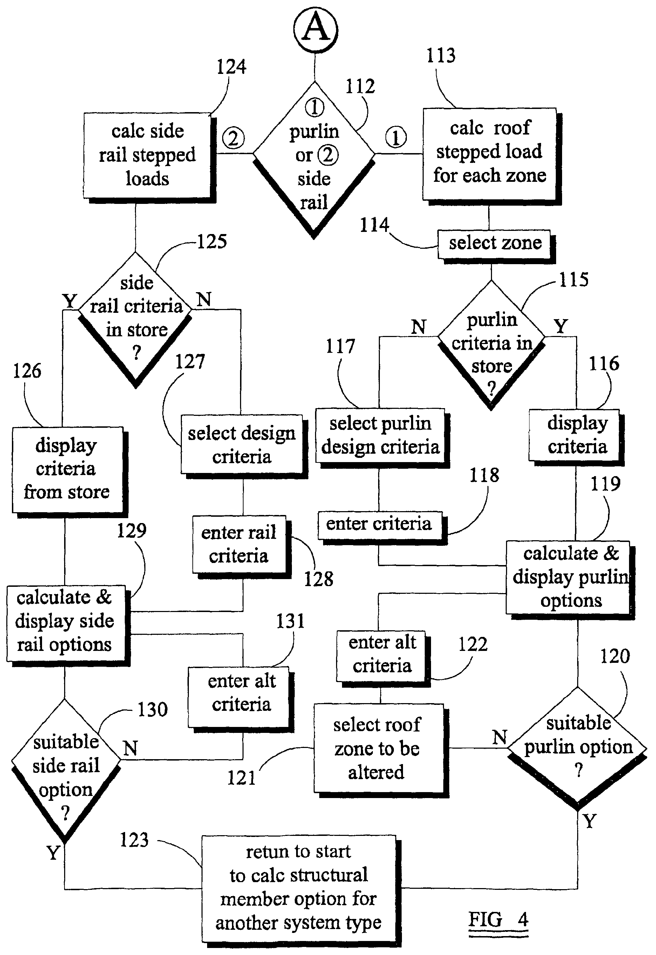

Once all of the desired wind load parameters and data have been entered following the series of prompts, they are saved in a memory (i.e. in a 'wind data file') at step 111 for subsequent application to a previously selected or to be later selected structural system type. The designer then selects whether to apply the wind load values to the purlin or side rail system as indicated at step 112 of figure 4. The case where the selected structural system type is roof purlin (selection 1 in step 112) will be described below.

In this case, the system is operative for retrieving the roof type (i.e. flat, duo-pitch, monopitch, hipped) from the body of data selected during entry of the relevant building dimension parameters during the wind load data entry phase of the system. If the designer selected the purlin system at step 102, the system will automatically recognise this following calculation of the wind load values. In response to this recognition, the system calculates a plurality of roof load cases for each of a predetermined number of roof purlin areas at step 113. That is to say, the system has means for rationalising the many different pressure zones on the building into a manageable number of purlin zones. The loads may be determined and displayed having regard to wind direction at zero and 90 degrees. For example, in the case of the duo-pitch roof, the predetermined purlin zones are: the ridge purlin zone, the eaves purlin zone, and the general purlin zone (i.e. the zone between the eaves and ridge).

For each purlin zone, the system will select a first selection of predetermined purlin criteria that includes the material properties and cross-section dimensional data for a known manufactured purlin product. These data, together with the loads are used in a finite element structural analysis program to calculate the internal forces (bending moments, stresses etc.) carried by the purlin. The calculated internal forces are compared with predetermined criteria, for example yield stresses and safety factors, to determine whether the selected purlin product passes or fails. The calculations may be repeated for a range of predetermined purlin criteria of known purlin products so as to present a scrollable list of products that pass the predetermined criteria comparison. The system may be further operative for displaying a first choice of purlin product based on the minimum purlin weight for products that pass the predetermined criteria comparison.

The general purlin zone will experience a uniform wind loading when considering the wind incident on the side of the building. On the other hand, the system will display a stepped loading when considering the wind incident on the gable end of the building. The system displays the calculated wind loads for the 'worst case' scenario for each one of the predetermined purlin zones. Purlin zone selection means may be provided for selecting between the wind loading results for each one of the predetermined areas in turn and applying these at step 114 to the wind load data to calculate and display at step 119 scrollable options for purlins usable in these areas. In addition, the system also carries out additional checks to satisfy gravity load conditions, i.e. loading due to dead load, service load and general imposed loading. The system thereby carries out a plurality of load case calculations and provides a solution that satisfies all of these cases. In other words, the system automatically takes the 'worst case' condition. However, before the system can display the purlin options, it determines at step 115 whether the purlin design parameter has been selected and purlin design data entered and stored at step 109. If so, the system displays the purlin design parameter and data at step 116 otherwise it prompts the designer for the purlin design parameters and data at step 117, enabling entry thereof at step 118.

Specifying the purlin design parameters and data will ensure that only those structural members falling within a desired class will be selected as a basis for calculating the structural member options. For example, the designer is prompted to select between purlin types including: sleeved; butt; overlap; and heavy end bay. Additional factors impinging on the calculation of the purlin member options may also be selected and included, such as: the cladding type (e.g. metal, cement or non-restraining cladding), span, centres, dead loading, service and imposed loading.

At step 119, the system may display the load capacity ratios, indicating for each purlin section: the number of sags: deflection: gravity load: wind uplift: weight and whether that purlin passes or fails according to prescribed load strength criteria. The designer is therefore able to scroll through the displayed purlin options indicated as being usable in the selected purlin zone. He is able to compare the purlin options for each one of the purlin zones and seek alternative purlin options in an attempt to find a single type which is suitable for all of the purlin zones. If, for example, at step 120 the designer should find that the only purlins indicated by the system as 'pass' for the eaves zone are heavier than those for the ridge and general roof zones, he can recalculate and display alternative purlin options for a selected one of the purlin zones at step 121. Following selection of the purlin zone for which the purlin options are to be recalculated, the designer enters one or more alternative parameters for the purlin design at step 122 so that the system recalculates the purlin options for the selected zone with the aim of finding a common purlin size for all zones. The designer can recalculate the purlins for the eaves zone on the basis of, for example, a 'drop-in-butt' system or on the basis of closer spacing without having to run through the entire wind loading program. A lighter purlin having a size, for example a depth, in common with those for the other roof areas may present itself among the scrollable options. In this example, although the recalculated purlins may be heavier for the ridge or eaves zones relative to the general roof zone, determination of a common purlin depth allows matching of compatible purlins so that adaptors are not required for inter-connecting different depth purlins.

Once the purlin design is completed, the designer can return to the start of the program at step 123 to calculate structural member options for another one of the structural system types, such as the side rails. Once calculated, either on an original or alternative parameter basis, the structural member options are stored in a memory for subsequent recall.

The system for calculating options for the side rails follows a similar logical flow to that of the purlins as indicated by steps 124 to 131 of figure 4. Following calculation of the stepped loads for the side rails at step 124, the system checks at step 125 to see whether side rail design parameters and data were entered into store at step 108. If not, the system prompts the designer at step 127 for design parameters and data, these being entered at step 128. On the other hand, if data is retrievable by the system, this is displayed at step 126. The options may be identified with reference to the dimensional sizes of the purlins or side rails and/or manufacturer's identification code. The sizes and codes are stored in a memory. When the side rail structural system type is selected instead of roof purlins, the parameters which may be selected includes, for example, Z or C sleeved/butt profiled rails. The calculated options are displayed at step 29.

The system therefore comprises means for recalculating, displaying and storing the structural member options such as the side rail parameters and data on the basis of an alternative parameter(s) (for example an alternative structural system type) using the plurality of wind load values stored at step 111. The designer is able to enter alternative design parameters and data for the side rails at step 131 following a negative view of the options at step 130 in a similar manner to the determination and establishment of suitable purlin options at step 120.

As the system calculates and stores the wind load values independently from the other parameters and data entered by the user, the user is only required to enter the alternative design parameters (e.g. system type) to generate a set of structural member options on a different basis. In other words, it is not necessary to re-enter parameters or data which is in common with that already entered into the system in connection with the calculation of previous sets of structural system options.

## Claims

1. A structural design system for a building structure comprising: a user input for receiving user-selected parameters, a user-selected alternative parameter and user-specified data relating to said building structure; an output for presenting structural member design options and/or alternative structural member design options; and a processing apparatus for processing data, the processing apparatus comprising:
a data memory operable to store data to be processed, including said user-specified data and reference data;
an instruction memory for storing a program comprising processor implementable instructions;
a processor operable to read and process data in accordance with said program;
wherein said program comprises instructions for controlling the processor to:
generate a plurality of wind load values which may be imposed on the building by wind in dependence on said user selected parameters, data read from said data memory and a predetermined wind load algorithm;
store said plurality of wind load values;
calculate structural member design options on the basis of said user selected parameters, data read from said data memory, said plurality of wind load values and predetermined structural design criteria; and
calculate alternative structural member design options on the basis of said user-selected alternative parameter and said plurality of wind load values.

2. A system according to claim 1 wherein said user-selected parameters include a structural system type selected from a group including purlins or side rails and said structural member design options comprise a list of available purlins or side rails respectively.

3. A system according to claim 2 wherein said user-specified data includes data relating to said structural system type and/or positional data of the building structure and/or dimensional data of said building structure.

4. A system according to any one of the preceding claims wherein the reference data includes a database of wind speeds based on geographical grid location, and/or a database of geographical grid locations based on town names, and/or look-up tables for facilitating determination of dynamic wind pressure from wind speed data using a method defined in accordance with an established standard, such as British Standard 6399 part 2.

5. A system according to any one of the preceding claims wherein the predetermined wind load algorithm is one of a plurality of wind load algorithms selectable by said user input.

6. A system according to any one of the preceding claims wherein the program further includes instructions for controlling the processor to calculate said alternative structural member design options for a selected part of the building structure to facilitate determination of a common structural member design type or size for the building structure.

7. A system according to claim 6 wherein said parts of the building are roof zones, the alternative structural member design options are purlins, and the user selected alternative parameter is a "drop-in-butt" system or is closer spacing of said purlins, such that the common structural member design type is a common purlin depth.

8. The system of claim 2 wherein the system types further include at least one of bracing and posts, ceiling/services and eaves beam options.

9. The system according to claim 3 wherein the positional data includes information as to the terrain in which the building is located.

10. The system according to any preceding claim wherein the computer program includes instructions for implementing calculation by the processor of any or all of the following:
equivalent site altitude, basic wind speed, upwind distance from the sea, and upwind distance from the edge of a town based on the positional and dimensional data and reference data;
default obstruction height, default separation from neighbouring buildings and terrain factors;
dynamic wind pressures in each orthogonal direction on each wall face of said building structure;
pressure coefficients based on dynamic wind pressures and dimensional data of the building structure;
wind loads on each wall and roof surface due to wind speeds in parallel and orthogonal directions and a gravity load for each wall and roof structure; and
structural member loads for predetermined structural member criteria using a finite element analysis method.

11. A method of structural design for a building structure comprising:
receiving user-selected parameters and user-specified data relating to a said building structure including positional and dimensional data;
generating a plurality of wind load values which may be imposed on the building by wind in dependence on said positional and dimensional data;
storing said plurality of wind load values;
calculating structural member design options on the basis of said user selected parameters, data read from a data memory, said plurality of wind load values and predetermined structural design criteria; and
calculating alternative structural member design options on the basis of a received user-selected alternative parameter and said plurality of wind load values.

12. The method of claim 11 further including the step of calculating said alternative structural member design options for a selected part of the building structure to determine a common structural member design type or size for the building structure.

13. A computer program carrier which when run on a computer:
provides for receiving a user-selection of parameters, a user-selection of an alternative parameter and user-specified data relating to a building structure including positional and dimensional data;
generates a plurality of wind load values which may be imposed on a building by wind in dependence on said positional and dimensional data;
stores the said plurality of wind load values,
calculates structural member design options on the basis of said parameters, reference data read from a data memory, said plurality of wind load values and predetermined structural design criteria; and
calculates alternative structural member design options on the basis of said user-selected alternative parameter and said plurality of wind load values.

14. The computer program carrier of claim 13, further containing said reference data, the reference data being copyable from the carrier to a data memory of the computer or readable directly from the carrier product.
